# EUROPEAN PATENT APPLICATION

(11) **EP 1 633 005 A1**
(43) Date of publication of application: **08.03.2006**
(21) Application number: 04020993.4
(22) Date of filing: 03.09.2004
(51) Int. Cl.: H01L 29/93

(54) **Monolithically integrated capacitor**

(71) Applicant: Infineon Technologies AG, 81669 München (DE)
(72) Inventor: Arnborg, Torkel, 11436 Stockholm (SE)
(74) Representative: Zinkler, Franz

(57) **Abstract**

An integrated capacitor having a variable capacitance and being formed in an SOI substrate, comprises a first region (12) lightly doped to a first doping type (P), a second region (13) doped to a second doping type (N+) opposite to the first doping type, and located at a first side of the first region, a third region (14) doped to the first doping type (P+) and located at a second side of the first region, which is opposite to the first side, an insulating region (15) on top of the first region, and a fourth doped region (16) located on top of the insulating region (15). The second and fourth doped regions are connected to a first electrode (17), and the third region is connected to a second electrode (18). The fourth doped region (16) is laterally separated from the third region (14) by a distance (d) to increase the range of the variable capacitance.

## Description

### TECHNICAL FIELD OF THE INVENTION

The present invention generally relates to the field of integrated circuit technology, and more specifically the invention relates to a monolithically integrated capacitor.

### DESCRIPTION OF RELATED ART AND BACKGROUND OF THE INVENTION

Capacitors with a capacitance value, which can be changed electronically by altering for example a voltage over the capacitor, are sometimes called varactors, varicaps or tunable capacitors. The term *varactor* means variable reactance, but is often used for the special case of variable capacitance. The varactors are used in radio applications to adapt the circuit to a given frequency. For example, a resonant circuit may be designed as a parallel combination of passive elements such as resistors R, inductors L and capacitors C. By changing the capacitance, which is usually easier than changing the inductance, it is possible to tune into the desired frequency. A voltage controlled oscillator (VCO), which has a voltage controlled variable signal frequency, can be fabricated using a variable capacitor.

Electronically controlled capacitors have been used since a long time using standard vacuum tubes, solid state diodes, bipolar transistors and MOS transistors. They all have built-in capacitors that can be used directly or together with circuitry that can give the desired control functions. Special devices to optimize the variable capacitance performance have been used and most of them have been utilizing special geometries and doping profiles rather than introducing new concepts. The reason for this is mainly the desired simplicity in order to avoid expensive fabrication processes.

The tunable capacitors fall in the category of pn-junction devices, such as e.g. diodes, or hetero-junction devices, such as e.g. MOS capacitors.

There are many quality measures of capacitors relevant for various applications. In radio frequency applications the most important such measures are Q-value, tuning range, linearity, reproducibility and size. Here the main focus is put on the first two of these.

The capacitance to be varied C(U), by a voltage U, is for pn-junctions and hetero-junctions caused by a depleted layer with a variable boundary distance W(U) from the junction. For ideal conditions the thickness is proportional to the inverse square root of the applied voltage. For the MOS case the only difference is that there is a series oxide capacitor and an additional electrode that can be used to change the depletion layer.

It is known that conventional MOS varactors have a limited capacitance variation, see e.g. J. Maget, M. Tiebout and R. Kraus: "Influence of novel MOS varactors on the performance of a fully Integrated UMTS VCO in standard 0.25-um CMOS Technology", IEEE Journal of Electron Devices, Volume: 37 Issue: 7, July 2002, pages 953-958. The key problem is that the capacitance is a sum of a variable capacitance Cᵥₐᵣ that can be varied between a minimum capacitance Cₘᵢₙ and a maximum capacitance Cₘₐₓ, and a constant parasitic capacitance Cₚ. This gives a tuning range of (Cₘₐₓ+Cₚ)/(Cₘᵢₙ+Cₚ), wherein it is easily notable that the range is degraded if the parasitic capacitance Cₚ is large. The parasitic capacitance Cₚ is limited by overlaps of the gate electrode and/or inactive pn-junctions. Typical values of the tuning range of a standard MOS varactor is about 2-3, whereas those of a varactor with reduced overlap capacitance are almost twice higher.

### SUMMARY OF THE INVENTION

It is an object of the present invention to provide a monolithically integrated capacitor having a variable capacitance, which is tunable over a larger range, than what is possible with the prior art capacitors described above.

It is in this respect a particular object of the invention to provide such a capacitor, which has a lower parasitic capacitance.

It is a further object of the invention to provide such a capacitor, which is formed in an SOI substrate.

It is yet a further object of the invention to provide such a capacitor, which can be fabricated easily and straightforward.

These objects are according to the present invention attained by monolithically integrated capacitors as claimed in the appended patent claims.

According to an aspect of the present invention, there is provided a monolithically integrated capacitor having a variable capacitance, being formed in an SOI substrate, and comprising a first region lightly doped to a first doping type, a second region doped to a second doping type opposite to the first doping type, and located at a first side of the first region, a third region doped to the first doping type and located at a second side of the first region, which is opposite to the first side, an insulating region on top of the first region, and a fourth doped region located on top of the insulating region. The second and fourth doped regions are connected to a first electrode, and the third region is connected to a second electrode. The fourth doped region is laterally separated from the third region by a distance to reduce the parasitic capacitance and to thereby increase the tuning range of the variable capacitance.

Preferably, the integrated capacitor is fabricated in a CMOS SOI process, wherein the monolithically integrated capacitor can be described as a conventional MOS transistor where the drain region doping type has been changed to the opposite doping type, and where the gate is shorter or the drain region has been moved away from the gate, so that there exists a lateral separation distance between the gate and the drain region.

The variable capacitance operation is obtained by having a depletion layer boundary moved in the first region depending on a voltage applied over the capacitor. The capacitor may be a partially or fully depleted SOI device.

In the partially depleted case the depletion layer boundary is moved both horizontally (in the lower portion of the first region close to the second region) and vertically (in the upper middle portion of the first region).

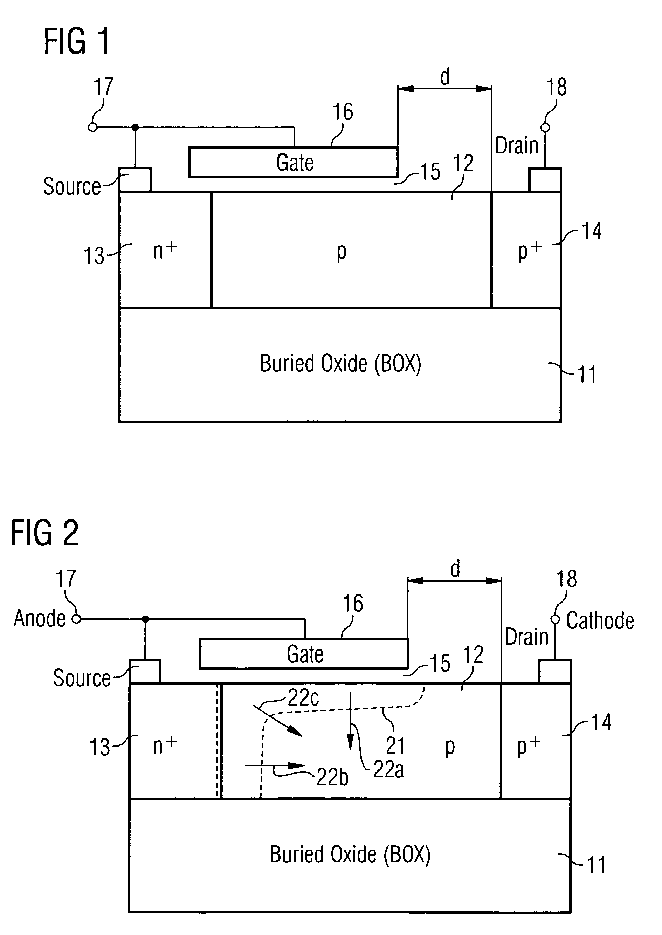

Further characteristics of the invention and advantages thereof will be evident from the detailed description of preferred embodiments of the present invention given hereinafter and the accompanying Figs. 1-5, which are given by way of illustration only, and are thus not limitative of the present invention.

### BRIEF DESCRIPTION OF THE DRAWINGS

Fig. 1 is a highly enlarged cross-sectional view of a monolithically integrated capacitor according to a preferred embodiment of the present invention.
Figs. 2-3 are highly enlarged cross-sectional views of the monolithically integrated capacitor of Fig. 1 configured for different depletion conditions.
Fig. 4 is a diagram of the capacitance as a function of applied voltage for partially and fully depleted capacitors of the present invention, as well as for a prior art capacitor.
Fig. 5 is a layout of a monolithically integrated capacitor according to a further preferred embodiment of the present invention.

### DETAILED DESCRIPTION OF PREFERRED EMBODIMENTS

A first preferred embodiment of a monolithically integrated capacitor with a variable capacitance implemented in MOS SOI technology according to a preferred embodiment of the present invention will be described with reference to Fig. 1.

The capacitor, formed in an SOI substrate, comprises a first layer region 12 lightly doped to a first doping type (e.g. P), a second layer region 13 doped to a second doping type (e.g. N+) opposite to the first doping type, and located at a first side of the first layer region 12, and a third layer region 14 doped to the first doping type (e.g. P+) and located at a second side of the first layer region 12, which is opposite to the first side. The three layer regions 12, 13, 14 are formed by e.g. ion implantation in the monocrystalline silicon top layer of the SOI substrate so that they extend down to the insulating layer 11 of the SOI substrate.

A thin insulating layer region 15, preferably of silicon oxide, is provided on top of the first layer region 11, and a fourth doped (e.g. N+ doped) layer region 16 is provided on top of the insulating layer region 15.

The second 13 and fourth 16 doped regions are connected to a first electrode 17, and the third region 14 is connected to a second electrode 18. The fourth doped region 16 is, according to the present invention, laterally separated from the third layer region 14 by a distance d to reduce the parasitic capacitance and to thereby increase the range of the variable capacitance.

The capacitor structure can be described as a conventional MOS transistor (e.g. an NMOS transistor) where the drain region doping type (e.g. N+) has been changed to the opposite doping type (e.g. P+) and where the gate is shorter or the drain has been moved away from the gate, so that there exists a lateral separation distance between the gate and the drain. Thus, the first layer region 12 is the lightly doped region between the source and the drain in a MOS transistor, which may be referred to as *bulk, well* or *substrate.* The second layer region 13 is the source, the third layer region 14 is the drain but with opposite doping, the thin insulating layer region 15 is the gate oxide, and the fourth doped layer region 16 is the gate silicon.

The inventive variable capacitance capacitor or varactor can be tailored to be either a partially depleted or a fully depleted SOI device.

In traditional varactors the depletion layer boundary is moved in the first layer region 12 in one space dimension when the applied voltage over the capacitor is varied. In an inventive partially depleted SOI capacitor, the depletion layer boundary 21 is moving sideways and downwards simultaneously as shown in Fig. 2. In the middle of the first layer region 12 close to the insulating layer region 15 the depletion layer boundary 21 is moved purely vertically as being indicated by arrow 22a, and in the left portion of the first layer region 12 close to the second layer region 13 the depletion layer boundary 21 is moved purely horizontally as being indicated by arrow 22b. As a result, the depletion layer boundary 21 is moved horizontally and vertically in the upper left corner of the first layer region 12 as being indicated by arrow 22c.

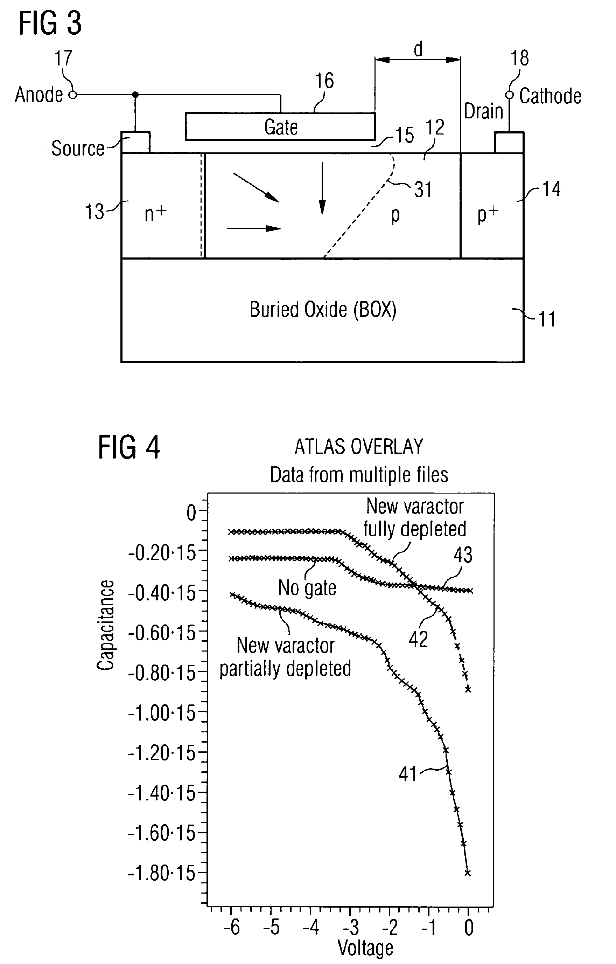

An inventive fully depleted SOI capacitor is illustrated in Fig. 3. Here, the depletion layer boundary is indicated by 31. The depletion layer extends down to the SOI insulating layer 11 along a major part of its lateral extension. The SOI insulating layer 11 will prevent any undepleted regions.

The lateral separation distance d between the fourth doped layer region 16 and the third layer region 14 ought to be long enough to assure that the depletion layer boundary cannot be moved all the way to the third monocrystalline layer region 14 independently of the voltage applied over the capacitor.

The inventive capacitor or varactor consists of two junctions: a MOS-junction and a pn-junction. The depletion layer variation with voltage is similar for the two junctions, and when this layer is small, the boundary of the capacitor is the sum of the two depletion layer boundaries. If they did not interact the capacitor would behave like a parallel combination of the pn-junction capacitor and the MOS-junction capacitor. However as the two depletion layers reach each other the C(U) relation will change. In Simon Sze, "Semiconductor technology", 1981, Wiley, chapters "Spherical junctions", page 73, and "Varactors", page 114 is found a comparison of how depletion layer boundaries extend for planar, circular and spherical junctions. In the present case and as a result the distance W(U) of the depletion layer boundary from the junction is changing faster with the voltage U, and accordingly the capacitance C(U) is also changing faster with the voltage U.

The capacitance as a function of voltage is shown in Fig. 4 for an inventive partially depleted capacitor 41, for an inventive fully depleted capacitor 42, and for a conventional pn-junction varactor implemented as a vertical source-well junction 43, respectively. The capacitance variation is small at low and high voltages for the conventional pn-junction varactor. The inventive capacitors show a strong capacitance variation. The partially depleted capacitor has a substantial capacitance slope at all voltages, whereas the fully depleted capacitor has a capacitance approaching a constant value for high voltages. This is due to the fact that no further depletion can be obtained.

The parasitic capacitance Cₚ limiting the tuning range has no contribution from the gate-source overlap since the gate is connected to the source. The gate-drain capacitance is very small since instead of a lateral overlap typically present in a transistor, a depletion layer is obtained below the edge of the gate. Finally the oxide layer below the silicon will cause partial or full depletion as in all SOI devices to further reduce the parasitic capacitance Cₚ.

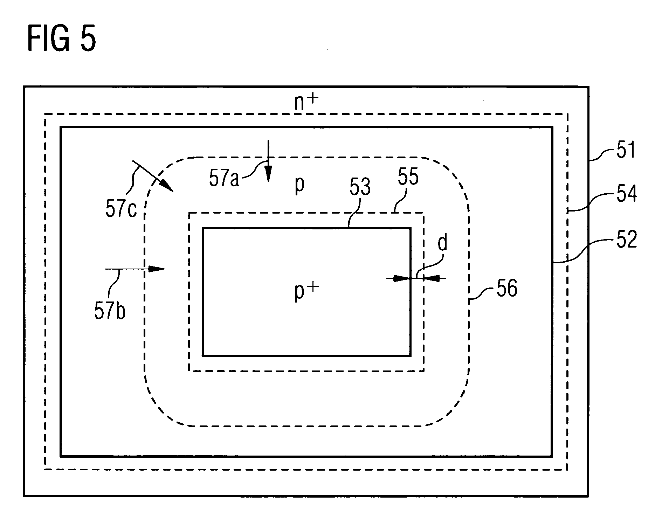

With reference now to Fig. 5, which shows a layout of a monolithically integrated capacitor, a further embodiment of the present invention will be described. This monolithically integrated capacitor, which has a ring-shaped layout, has preferably a cross-section according to Fig. 2. In Fig. 5 reference numeral 51 and 52 delimit the second layer region 13 (doped to N+); 52 and 53 delimit the first layer region 12 (doped to P); 53 delimits the third layer region 14 (doped to P+); and 54 and 55 delimit the fourth doped layer region 16. The depletion layer boundary is indicated by reference numeral 56. While the ring shape of the illustrated capacitor is quadratic, it may equally well be rectangular, circular, or elliptical.

As shown in Fig. 5 it is possible to let the depletion layer boundary movement, which was controlled by two orthogonal movements in the embodiment of Fig. 2, be controlled by three orthogonal movements in this embodiment. The depletion layer boundary 56 is moved horizontally and vertically in the upper portion of the first layer region 12 close to the second layer region 13 as being indicated by arrows 57a-b. However, the horizontal movements of the depletion layer boundary 56 are, at these two positions, orthogonal. Thus at a position close to a corner of the first layer region 12, the depletion layer boundary 56 is moved in three orthogonal directions as being indicated by arrow 57c. This layout will probably cause the tuning range to increase further.

By the principles of the present invention, a capacitor or varactor with large tuning range and high Q-value may be fabricated with minor changes to a standard MOS SOI process without using trenches. Using a conventional CMOS process, typically only one additional mask has to be used to not implant the first layer region 12 outside of the gate area.

While the present invention is primarily intended for radio frequency silicon devices, it may as well be useful for other kind of SOI devices.

Further, the capacitor of the present invention may be fabricated with inverted doping types so that the capacitor will be similar to a PMOS SOI transistor instead of an NMOS SOI transistor.

## Claims

1. A monolithically integrated capacitor having a variable capacitance, comprising:
- a first monocrystalline layer region (12) doped to a first doping type (P),
- a second monocrystalline layer region (13) doped to a second doping type (N) and located at a first side of said first monocrystalline layer region, said second doping type being opposite to said first doping type,
- a third monocrystalline layer region (14) doped to the first doping type (P+) and located at a second side of said first monocrystalline layer region, said second side being opposite to said first side, and said third monocrystalline layer region being more heavily doped than said first monocrystalline layer region,
- a layer region (15) of an insulating material on top of said first monocrystalline layer region,
- a doped layer region (16) on top of said layer region (15) of insulating material,
- a first electrode (17) of said capacitor connected to said second monocrystalline layer region (13) and said doped layer region (16), and
- a second electrode (18) of said capacitor connected to said third monocrystalline layer region (14), **characterized in that**
- said monolithically integrated capacitor is formed on a layer (11) of an insulating material, and
- said doped layer region (16) is laterally separated from said third monocrystalline layer region (14) by a distance (d).

2. The monolithically integrated capacitor of claim 1 wherein a depletion layer boundary (21; 31) is provided to be moved in said first monocrystalline layer region (12) depending on a voltage applied over said capacitor to thereby obtain said variable capacitance.

3. The monolithically integrated capacitor of claim 2 wherein said distance (d) is long enough to assure that said depletion layer boundary (21; 31) cannot be moved all the way to said third monocrystalline layer region (14) independently of the voltage applied over said capacitor.

4. The monolithically integrated capacitor of claim 2 or 3 wherein said depletion layer boundary (21; 31) is provided to be moved horizontally (22b) in a lower portion of said first monocrystalline layer region (12) and vertically (22a) in an upper portion of said first monocrystalline layer region (12).

5. The monolithically integrated capacitor of any of claims 2-4 wherein said first, second and third monocrystalline layer regions are provided in a ring shaped fashion, and said depletion layer boundary (21; 31) is provided to be moved three-dimensionally in said first monocrystalline layer region (12).

6. The monolithically integrated capacitor of any of claims 1-5 wherein said capacitor is integrated with CMOS transistors in an SOI substrate.

7. The monolithically integrated capacitor of any of claims 1-6 wherein said capacitor is a partially depleted SOI device.

8. The monolithically integrated capacitor of any of claims 1-6 wherein said capacitor is a fully depleted SOI device.
